# EUROPEAN PATENT APPLICATION

(11) **EP 4 415 260 A1**
(43) Date of publication of application: **14.08.2024**
(21) Application number: 23804887.0
(22) Date of filing: 08.02.2023
(51) Int. Cl.: H03H 9/17, H03H 9/02, H03H 3/02

(54) **BULK ACOUSTIC WAVE RESONATOR, MANUFACTURING METHOD THEREFOR, FILTER AND ELECTRONIC DEVICE**

(30) Priority: 23.12.2022 CN 202211663396
(71) Applicant: JWL (Zhejiang) Semiconductor Co., Ltd., Huzhou, Zhejiang 313000 (CN)
(72) Inventor: LI, Linping, Huzhou, Zhejiang 313000 (CN)
(74) Representative: Kolster Oy Ab
(86) International application number: PCT/CN2023/074927
(87) International publication number: WO 2024/130823

(57) **Abstract**

A bulk acoustic resonator, a method for manufacturing the bulk acoustic resonator, a filter, and an electronic device are provided. A frame structure is arranged at an edge of an effective resonance region configured in the bulk acoustic resonator. An acoustic impedance of the effective resonance region corresponding to the frame structure is greater than an acoustic impedance of the effective resonance region that is outside the frame structure, which effectively suppresses parasitic transverse waves. In addition, as the frame structure includes two passivation layers, it can reduce clutter caused by additional resonance while suppressing the transverse waves. Furthermore, with the structure of the two passivation layers, the stress can be reduced and the structure stability and a Q factor can be improved.

## Description

This application claims priority to Chinese Patent Application No. 202211663396.9, titled "BULK ACOUSTIC RESONATOR AND METHOD FOR MANUFACTURING THE SAME, FILTER AND ELECTRONIC DEVICE", filed on December 23, 2022 with the Chinese Patent Office, which is incorporated herein by reference in its entirety.

### FIELD

The present disclosure relates to the field of semiconductor technology, and in particular to a bulk acoustic resonator, a method for manufacturing a bulk acoustic resonator, a filter, and an electronic device.

### BACKGROUND

A bulk acoustic resonator has a "sandwich" basic structure formed by stacking a bottom electrode, a piezoelectric layer, and a top electrode. When a high frequency electrical signal is applied between the top electrode and the bottom electrode, bulk acoustic waves (BAW) propagating in a thickness direction of the piezoelectric layer are excited in the piezoelectric layer due to the reverse piezoelectric effect of the piezoelectric layer. A length of a propagation path of the bulk acoustic waves is equal to a total thickness of the top electrode, the bottom electrode, and the piezoelectric layer. In a case that a wavelength of the bulk acoustic wave and the length of the propagation path meet a certain relationship, a standing wave oscillation is formed. In this case, the signal resonates inside the material, where equivalent impedance of the device reaches an extremum. In order to optimize performance of the bulk acoustic waves in high frequency bands (greater than 1GHz), an optimal solution is to miniaturize the "sandwich" structure from a block structure to a thin-film structure.

In conventional technology, bulk acoustic resonators are structurally divided into solidly mounted resonators (SMR) using a Bragg reflector layer structure, and back-etching type and air-gap acoustic resonators using air as a reflection medium. The back-etching type and air-gap acoustic resonators using air as a reflection medium are usually referred to as thin film bulk acoustic resonators (FBARs), and the bulk acoustic resonators using a Bragg reflection layer are usually referred to as SMR-BAWs.

While serving as a radio frequency device, the FBAR is required to apply a radio frequency voltage to two electrodes of the FBAR as a power source. An alternating electric field is generated in the piezoelectric layer under the radio frequency voltage. Due to the reverse piezoelectric effect, the piezoelectric layer is deformed, which is shown as vibration of phonons at a micro level and shown as acoustic waves at a macro level. Such acoustic waves are bulk acoustic waves inside the piezoelectric layer. In this way, the electrical energy is converted into the mechanical energy. The bulk acoustic wave is reflected back and forth between the top electrode and the bottom electrode. According to the condition for forming the standing wave, the standing wave oscillation takes place in a case that a propagation distance of the acoustic wave is equal to a half wavelength or an odd multiple of the half wavelength. Due to the piezoelectric effect, the bulk acoustic waves reflected back and forth excite a radio frequency electrical signal, where the mechanical energy is converted into electrical energy in turn, thus forming the resonance of the electrical signal.

According to relationship between a polarization direction and a propagation direction of the bulk acoustic wave, there are two vibration modes of the FBAR, including a longitudinal mode and a transverse mode. The longitudinal mode is the fundamental resonance. In the longitudinal mode, longitudinal waves exhibit periodic back-and-forth motion between electrodes, with a same phase at all positions between the electrodes. The longitudinal waves propagate in a Z-axis of the piezoelectric layer of the FBAR. A cavity is arranged between a substrate and the bottom electrode, so that the longitudinal waves are reflected back to a resonance region at an interface between the bottom electrode and the air to eliminate loss of acoustic energy. The transverse mode is a parasitic mode. While generating the longitudinal waves, the resonator also generates the transverse waves. The transverse wave oscillation causes energy leakage at a boundary of an effective region of the resonator, which results in an energy loss so as to compromise a Q factor.

In order to reduce the impact of the transverse mode on the Q factor, a frame structure can be arranged at an edge of an effective resonance region on the top electrode. The frame structure is usually made of the same material as the top electrode. In other words, the frame structure is actually a part of the top electrode. Although the frame structure has a beneficial effect on the Q factor, since the metal frame structure electrically connected to the top electrode is arranged in the effective resonance region, the metal frame structure introduces a stray signal while suppressing the transverse wave, which compromises the longitudinal mode.

Hence, it is a crucial problem for filter design engineers to consider how to eliminate noises while reducing the impact of the transverse mode on the Q factor.

### SUMMARY

In view of this, a bulk acoustic resonator, a method for manufacturing a bulk acoustic resonator, a filter, and an electronic device are provided according to the embodiments of the present disclosure, to eliminate noise while reducing the impact of the transverse mode on the Q factor.

To this end, technical solutions are provided according to the embodiments of the present disclosure as follows.

In a first aspect of the embodiments of the present disclosure, a bulk acoustic resonator is provided. The bulk acoustic resonator includes:
a substrate;
a bottom electrode, a piezoelectric layer, and a top electrode that are stacked above the substrate;
an acoustic reflection structure, arranged between the substrate and the bottom electrode, where an overlapping region of the bottom electrode, the piezoelectric layer, the top electrode, and the acoustic reflection structure is configured as an effective resonance region of the bulk acoustic resonator; and
a frame structure, arranged at an edge of the effective resonance region, where the frame structure includes a second passivation layer, a first material layer, and a first passivation layer that are stacked above the top electrode; one end of the frame structure is located within the effective resonance region, another end of the frame structure extends at least to the edge of the effective resonance region to align with the edge, and an acoustic impedance of an effective resonance region corresponding to the frame structure is greater than an acoustic impedance of an effective resonance region that is outside the frame structure.

In an embodiment, the first material layer is made of a metal material.

In an embodiment, the first material layer is made of a non-metallic material.

In an embodiment, the first material layer and the second passivation layer are fabricated as/from a same layer.

In an embodiment, the frame structure further includes a second material layer arranged between the first material layer and the first passivation layer.

In an embodiment, the second material layer is made of a material different from a material of the first passivation layer and different from a material of the second passivation layer.

In an embodiment, the second material layer is made of a metal material.

In an embodiment, both the first passivation layer and the second passivation layer cover the effective resonance region.

In an embodiment, the first passivation layer covers the effective resonance region, and the second passivation layer is arranged at the edge of the effective resonance region. Alternatively, the second passivation layer covers the effective resonance region, and the first passivation layer is arranged at the edge of the effective resonance region.

In an embodiment, an acoustic impedance of the second passivation layer is greater than an acoustic impedance of the first passivation layer.

In an embodiment of the present disclosure, as an acoustic impedance of the second passivation layer is greater than an acoustic impedance of the first passivation layer, the acoustic loss is reduced, which is conducive to suppressing parasitic transverse waves.

In an embodiment, the acoustic impedance of the effective resonance region corresponding to the frame structure is no less than the acoustic impedance of a region that is outside the frame structure.

In an embodiment, the acoustic reflection structure is a Bragg reflection layer or a cavity.

In an embodiment, the cavity is arranged inside the substrate or above the substrate.

In an embodiment, the acoustic reflection structure further includes a first dielectric layer and a second dielectric layer, where the first dielectric layer is arranged between the bottom electrode and the second dielectric layer; a third material layer is arranged between the first dielectric layer and the second dielectric layer, and the third material layer is arranged at the edge of the effective resonance region, one end of the third material layer is located within the effective resonance region, another end of the third material layer extends at least to the edge of the effective resonance region to align with the edge, and an acoustic impedance of an effective resonance region corresponding to the third material layer is greater than an acoustic impedance of an effective resonance region that is outside the third material layer.

In an embodiment, the third material layer and the first dielectric layer are fabricated as/from a same layer.

In an embodiment, an upper surface of the first material layer is configured as an uneven structured surface.

In an embodiment, an upper surface of the second material layer is configured as an uneven structured surface.

In an embodiment, an upper surface of a part of the first passivation layer corresponding to the first material layer is configured as an uneven structured surface, an uneven structure on the uneven structured surface thereof and an uneven structure on the uneven structured surface of the first material layer are arranged alternatively.

In an embodiment, an upper surface of a part of the first passivation layer corresponding to the second material layer is configured as an uneven structured surface, an uneven structure on the uneven structured surface thereof and an uneven structure on the uneven structured surface of the second material layer are arranged alternatively. By arranging the upper surfaces of the first passivation layer, the first material layer and/or the second material layer as uneven structured surfaces, small parasitic transverse wave near fs can be reduced or eliminated.

In a second aspect of the embodiments of the present disclosure, a method for manufacturing a bulk acoustic resonator is provided. The method includes:
providing a substrate;
sequentially forming a bottom electrode, a piezoelectric layer, and a top electrode on the substrate and forming an acoustic reflection structure between the substrate and the bottom electrode, where an overlapping region of the bottom electrode, the piezoelectric layer, the top electrode and the acoustic reflection structure is configured as an effective resonance region of the bulk acoustic resonator;
forming a frame structure at an edge of the effective resonance region, where the frame structure includes a second passivation layer, a first material layer, and a first passivation layer that are sequentially formed above the top electrode, one end of the frame structure is located within the effective resonance region, another end of the frame structure extends at least to the edge of the effective resonance region to align with the edge, and an acoustic impedance of an effective resonance region corresponding to the frame structure is greater than an acoustic impedance of an effective resonance region that is outside the frame structure.

In a third aspect of the embodiments of the present disclosure, a filter is provided. The filter includes the bulk acoustic resonator according to the first aspect of the embodiments of the present disclosure.

In a fourth aspect of the embodiments of the present disclosure, an electronic device is provided. The filter includes the bulk acoustic resonator according to the first aspect of the embodiments of the present disclosure.

In the embodiments of the present disclosure, a frame structure is arranged at an edge of an effective resonance region configured in the bulk acoustic resonator. An acoustic impedance of the effective resonance region corresponding to the frame structure is greater than an acoustic impedance of the effective resonance region that is outside the frame structure, which effectively suppresses parasitic transverse waves. In addition, as the frame structure includes two passivation layers, it can reduce clutter caused by additional resonance while suppressing the transverse waves. Furthermore, with the structure of the two passivation layers, the stress can be reduced and the structure stability and a Q factor can be improved. Where, the first passivation layer among the two passivation layers is a frequency modulation layer, to avoid deterioration of the frame structure during a frequency modulation process.

### BRIEF DESCRIPTION OF THE DRAWINGS

For clearer illustration of the technical solutions according to embodiments of the present disclosure or conventional techniques, hereinafter are briefly described the drawings to be applied in embodiments of the present disclosure or conventional techniques. Apparently, the drawings in the following descriptions are only some embodiments of the present disclosure, and other drawings may be obtained by those ordinary skilled in the art based on the provided drawings without creative efforts.
Figure 1 is a schematic cross-sectional view of a bulk acoustic resonator according to an embodiment of the present disclosure;
Figure 2 is a schematic cross-sectional view of a bulk acoustic resonator according to another embodiment of the present disclosure;
Figure 3 is a graph of a frequency-impedance curve related to the quantity of clutter obtained from simulations based on Figure 2;
Figure 4 is a graph of a frequency-impedance curve related to amplitudes of clutter obtained from simulations based on Figure 2;
Figure 5 is a graph of a frequency-impedance curve related to Rs value obtained from simulations based on Figure 2;
Figure 6 is a graph of a frequency-impedance curve related to Rp value obtained from simulations based on Figure 2;
Figure 7 is a graph of a frequency-impedance curve related to fp obtained from simulations based on Figure 2;
Figure 8 is a schematic cross-sectional view of a bulk acoustic resonator according to another embodiment of the present disclosure;
Figure 9 is a schematic cross-sectional view of a bulk acoustic resonator according to another embodiment of the present disclosure;
Figure 10 is a schematic cross-sectional view of a bulk acoustic resonator according to another embodiment of the present disclosure;
Figure 11 is a schematic cross-sectional view of a bulk acoustic resonator according to another embodiment of the present disclosure;
Figure 12 is a schematic cross-sectional view of a bulk acoustic resonator according to another embodiment of the present disclosure;
Figure 13 is a schematic cross-sectional view of a bulk acoustic resonator according to another embodiment of the present disclosure;
Figure 14 is a schematic cross-sectional view of a bulk acoustic resonator according to another embodiment of the present disclosure;
Figure 15 is a schematic cross-sectional view of a bulk acoustic resonator according to another embodiment of the present disclosure;
Figure 16 is a schematic cross-sectional view of a bulk acoustic resonator according to another embodiment of the present disclosure;
Figure 17 is a graph of a frequency-impedance curve related to the quantity of clutter obtained from simulations based on Figure 16;
Figure 18 is a graph of a frequency-impedance curve related to amplitudes of clutter obtained from simulations based on Figure 16;
Figure 19 is a graph of a frequency-impedance curve related to Rs value obtained from simulations based on Figure 16;
Figure 20 is a graph of a frequency-impedance curve related to Rp value obtained from simulations based on Figure 16;
Figure 21 is a schematic cross-sectional view of a bulk acoustic resonator according to another embodiment of the present disclosure;
Figure 22 is a schematic cross-sectional view of a bulk acoustic resonator according to another embodiment of the present disclosure; and
Figure 23 is a schematic cross-sectional view of a bulk acoustic resonator according to another embodiment of the present disclosure.

### DETAILED DESCRIPTION OF EMBODIMENTS

Hereinafter the technical solutions in the embodiments of the present disclosure are described clearly and thoroughly in conjunction with the accompanying drawings in the embodiments of the present disclosure. Apparently, the described embodiments are only some rather than all of the embodiments of the present disclosure. Any other embodiments obtained based on the embodiments of the present disclosure by those ordinary skilled in the art without any creative effort fall within the scope of protection of the present disclosure.

In the present disclosure, the terms such as "include", "comprise" or any other variants thereof means to be non-exclusive. Therefore, a process, method, article or device including a series of elements includes not only the disclosed elements but also other elements that are not clearly enumerated, or further includes inherent elements of the process, method, article or device. Unless expressively limited, the statement "comprising/including a(n) ..." does not exclude the case that other similar elements may exist in such process, method, article or device other than enumerated elements.

The technical solutions of the embodiments of the present disclosure are described clearly and thoroughly below in conjunction with the drawings of the embodiments of the present disclosure.

### First Embodiment

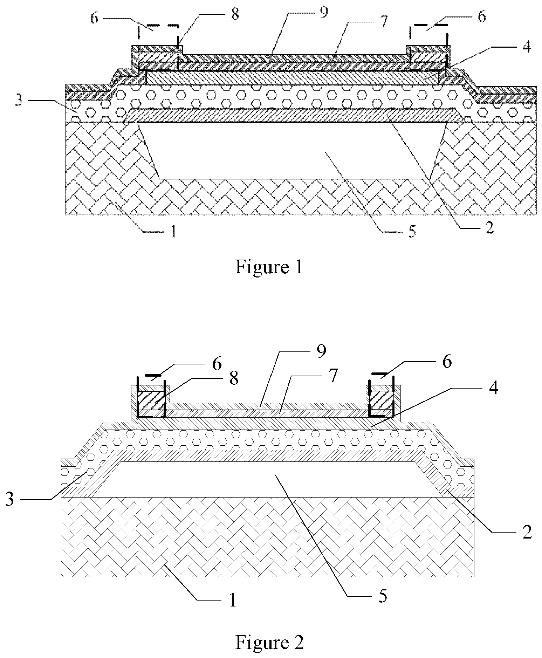

Figure 1 is a schematic cross-sectional view of a bulk acoustic resonator according to a first embodiment of the present disclosure. The bulk acoustic resonator includes a substrate 1, a bottom electrode 2, a piezoelectric layer 3, a top electrode 4, and an acoustic reflection structure 5. The bottom electrode 2, the piezoelectric layer 3, and the top electrode 4 are stacked above the substrate 1. The acoustic reflection structure 5 is arranged between the substrate 1 and the bottom electrode 2. An overlapping region of the bottom electrode 2, the piezoelectric layer 3, the top electrode 4 and the acoustic reflection structure 5 is configured as an effective resonance region of the bulk acoustic resonator.

Where, the bulk acoustic resonator further includes frame structures 6 arranged at edges of the effective resonance region. Each frame structure 6 includes a second passivation layer 7, a first material layer 8, and a first passivation layer 9 that are stacked above the top electrode 4. The second passivation layer 7 is arranged between the first passivation layer 9 and the top electrode 4. The first material layer 8 is arranged between the first passivation layer 9 and the second passivation layer 7.

One end of the frame structure 6 is located within the effective resonance region, and another end of the frame structure 6 extends at least to the edge of the effective resonance region to align with that edge. The acoustic impedance of the effective resonance region corresponding to the frame structure 6 is greater than the acoustic impedance of the effective resonance region that is outside the frame structure 6. In this way, parasitic transverse waves can be effectively reflected or suppressed.

In the first embodiment of the present disclosure, the frame structure 6 is located at the edge of the effective resonance region, which includes the second passivation layer 7, the first material layer 8, and the first passivation layer 9 that are stacked above the top electrode 4.

In an embodiment, one end of the frame structure 6 may be located within the effective resonance region, and another end of the frame structure 6 may align with an end edge of the top electrode 4 or the bottom electrode 2. Alternatively, the two ends of the frame structure 6 may be located on two sides of the end edge of the top electrode 4 or the bottom electrode 2 respectively, so as to form a frame with a circular protruding structure or a frame with a polygonal protruding structure that matches the boundary of the bottom electrode 2 or the top electrode 4, so that the acoustic impedance of the effective resonance region corresponding to the frame structure 6 is greater than the acoustic impedance of the effective resonance region that is outside the frame structure 6.

The acoustic reflection structure 5 in the first embodiment of the present disclosure is a cavity. The cavity is arranged inside the substrate 1. The first passivation layer 9 and the second passivation layer 7 both extend towards the effective resonance region and cover the effective resonance region.

It should be noted that in the bulk acoustic resonator, Rs represents a sum an ohmic loss and a lead loss of the device and Rp represents an energy factor of the bulk acoustic resonator. The larger Rp is, the less acoustic loss, represented by Rs, occurs, resulting in more energy from the bulk acoustic resonator being involved in the fundamental resonance. Hence, a device with large Rp has a large Q factor and a better acoustic structure. Therefore, it is desired to construct a bulk acoustic resonator with the Rs as small as possible and the Rp as large as possible at the same frequency.

The frame structure 6 according to the first embodiment of the present disclosure is different from the protruding structure made of a metal material in the conventional technology. The frame structure 6 is electrically isolated from the top electrode 4, and even is completely made of a non-metallic material, so that transverse waves can be effectively suppressed. The frame structure 6 is different from the protruding structure that is made of a metal material and is electrically connected to the top electrode in conventional technology. The conventional protruding structure is generally formed using evaporation and a lift-off process, resulting in a reliability problem of adhesion between the conventional protruding structure and the top electrode, which poses a risk of delamination. In the present disclosure, since the passivation layer is generally formed using a CVD process or a PVD process, the adhesion can be improved. In addition, with the frame structure 6 according to the present disclosure, additional oscillations formed in the oscillation stack can be reduced, thus minimizing the clutter near fs.

In an embodiment of the present disclosure, the first material layer 8 and the second passivation layer 7 are made of a same material and may be fabricated as/from a same layer.

The first passivation layer 9 in the first embodiment of the present disclosure is a frequency modulation layer, which eliminates deterioration of the frame structure 6 during a frequency modulation process. Where, the first passivation layer 9 achieves the function of frequency modulation, while the second passivation layer 7 and the first material layer 8 achieves the function of reducing the transverse wave loss. Such configuration eliminates the deterioration of the frame structure 6 during the frequency modulation process. In other words, it resolves conflicts arising from processes aimed at achieving different functions.

The first material layer 8 may be made of a non-metallic material different from a material of the first passivation layer 9 or the second passivation layer 7.

The first passivation layer 9 and the second passivation layer 7 may be made of a dielectric material including but not limited to SiO₂, Si₃N₄, AlN, Si, SiC, Ta₂O₅, Al₂O₃, TiO₂, HfO₂, ZrO₂, MgO, and DLC (diamond like carbon).

In determining the dielectric material of the first passivation layer 9 and the second passivation layer 7, it is considered that acoustic impedance in a longitudinal wave direction (the acoustic impedance in the present disclosure refers to an acoustic impedance in the longitudinal wave direction without additional explanation) generally ranges from 10MRayls to 100MRayls. Therefore, materials of the first passivation layer 9 and the second passivation layer 7 may be optimally determined based on a device model. For example, materials such as Si₃N₄, Ta₂O₅, or SiC with high acoustic impedance may be selected. Where, Si₃N₄ has an acoustic impedance of 36MRayls; Ta₂O₅ has an acoustic impedance of 39MRayls; and SiC has an acoustic impedance of 91MRayls. Specifically, the acoustic impedance of SiC is much greater than acoustic impedances of general dielectric materials.

In an embodiment of the present disclosure, the second passivation layer 7 may also be formed by multiple layers of materials with different acoustic impedances.

The first passivation layer 9 and the second passivation layer 7 may use the material with a high acoustic speed, for example, AlN has an acoustic speed of 11200m/s, SiC has an acoustic speed of 13000m/s, Al₂O₃ has an acoustic speed of 10520m/s, or Si₃N₄ has an acoustic speed of 11000m/s (the above acoustic speed data vary slightly in different articles).

The first passivation layer 9 and the second passivation layer 7 using the material with a high acoustic speed can reduce respective thicknesses of the first passivation layer 9 and the second passivation layer 7, so as to reduce an overall thickness of the passivation layers. In addition, a ratio of the overall thickness of the first passivation layer 9 and the second passivation layer 7 to a total longitudinal thickness of the entire device is reduced, which ensures an effective electromechanical coupling coefficient, thereby improving the performance of the device.

In the first embodiment and the following other embodiments of the present disclosure, the width and thickness of the frame structure 6 may be optimized based on the performance of the device.

In an embodiment of the present disclosure, the width of the frame structure 6 ranges from 1 µ M to 5 µ M, and the thickness of the frame structure 6 ranges from 10nm to 200nm. For a material with a high acoustic impedance, although the thickness of the material is relatively thin, it can excite a stray mode near fs, which undermines the performance of the device. An optimal width of the frame structure 6 is related to frequency and thickness of the frame structure 6, and the optimal width can be determined through collaborative optimization.

In the present disclosure, a frequency modulation process is a process for correcting the frequency, which is fundamentally similar to an etching process. The difference lies in the fact that the entire wafer is scanned, e.g., in a serpentine track, during the frequency modulation process, rather than etching the entire wafer all at once. This may apply varying degrees of etching or trimming to different regions of the entire wafer. The principle of the frequency modulation process is that physical bombardment is performed by using a particle beam to reduce the thickness of the thin film. Alternatively, both physical bombardment and chemical reaction are performed to reduce the thickness of the thin film. Therefore, after the frequency modulation, the first passivation layer 9 is thinned to varying degrees in different regions to achieve a desired target frequency. However, the thickness and the width of other parts of the frame structure 6 remain unchanged, which ensures that an acoustic physical model of the device remains unchanged, thereby ensuring consistency in performance of the device and improving a yield.

In the first embodiment and the following other embodiments in the present disclosure, the first passivation layer 9 and the second passivation layer 7 that are different in acoustic impedances are formed above the top electrode 4 and within the effective resonance region.

In an embodiment of the present disclosure, the acoustic impedance of the second passivation layer 7 close to the top electrode 4 is greater than the acoustic impedance of the first passivation layer 9.

Based on this, the second passivation layer 7 may be made of SiC, and the first passivation layer 9 may be made of Al₂O₃. Alternatively, the second passivation layer 7 is configured as tensile stress and the first passivation layer 9 is configured as compressive stress. The tensile stress and compressive stress can mutually offset stresses, to enhance the structure reliability. During the growth of the bottom electrode 2, the top electrode 4, and the piezoelectric layer 3, configuring the stresses to achieve stress balance can impact the device performance, in this case, it is challenging to simultaneously balance stress and performance. Therefore, the composite configuration of two passivation layer, i.e., the first passivation layer 9 and the second passivation layer 7, can achieve stress balance, thereby improving the structure stability and the Q factor.

In other words, the frame structure 6 includes two passivation layers, i.e., providing the first passivation layer 9 and the second passivation layer 7 both, to achieve stress balance. In this case, in configuring stresses for the bottom electrode 2, the top electrode 4, and the piezoelectric layer 3, it is only required to ensure optimal performance.

In the bulk acoustic resonator according to the first embodiment of the present disclosure, the frame structure 6 is arranged at the edge of the effective resonance region configured in the bulk acoustic resonator. On one hand, the arrangement of the frame structure 6 contributes to stress reduction. Additionally, the residual stress between the bottom electrode 2, the top electrode 4, and the piezoelectric layer 3 approaches zero after releasing a sacrificial layer within the cavity of the bulk acoustic resonator. This enhances the service life and stability of the bulk acoustic resonator. On the other hand, optimizing the thickness ratio based on the acoustic impedance coefficient is advantageous for suppressing transverse waves and achieving optimal performance.

Further, the frame structure 6 including two passivation layers is applicable to BAW filters with SMR structures. In other words, a Bragg reflection layer, as the acoustic reflection structure 5, is arranged under the bottom electrode 2, and the Bragg reflection layer is formed by stacking high-impedance materials and low-impedance materials alternatively. In a resonator for an SMR-BAW, the frame structure 6 is arranged above the top electrode 4, which improves Rp performance as mentioned above.

### Second Embodiment

Figure 2 is a schematic cross-sectional view of a bulk acoustic resonator according to a second embodiment of the present disclosure.

The second embodiment in the present disclosure differs from the first embodiment of the present disclosure in that the cavity is arranged above the surface of the substrate 1 and the frame structure 6 terminates at the edge of the effective resonance region. As shown in Figure 2, one end of the frame structure 6 is located within the effective resonance region, and another end of frame structure 6 aligns with the edge of the top electrode 4.

In order to compare the resonator performance in a case that the first material layer 8 is made of a metal material and the resonator performance in a case that the first material layer 8 is made of a non-metallic material, comparative validation is performed by using the structure in the second embodiment of the present disclosure as a simulation device. In a control group, the first material layer 8 is made of metal Mo, and the second passivation layer 7 in the second embodiment is replaced by a metal layer made of Mo. In an experimental group, the first material layer 8 and the second passivation layer 7 are made of a same material, namely silicon carbide, aluminum nitride, or silicon nitride.

In both the control group and the experimental group, the bottom electrode 2 and the top electrode 4 of the simulation device are made of molybdenum. The bottom electrode 2 and the top electrode 4 each has a thickness of 0.3 µ M. The piezoelectric layer 3 is made of aluminum nitride. The piezoelectric layer 3 has a thickness of 0.8 µ M. The first passivation layer 9 is made of aluminum nitride. The first passivation layer 9 has a thickness of 0.29 µ M. The first material layer 8 and the second passivation layer 7 each has a thickness of 0.05 µ M. The first material layer 8 has a width of 2 µ M.

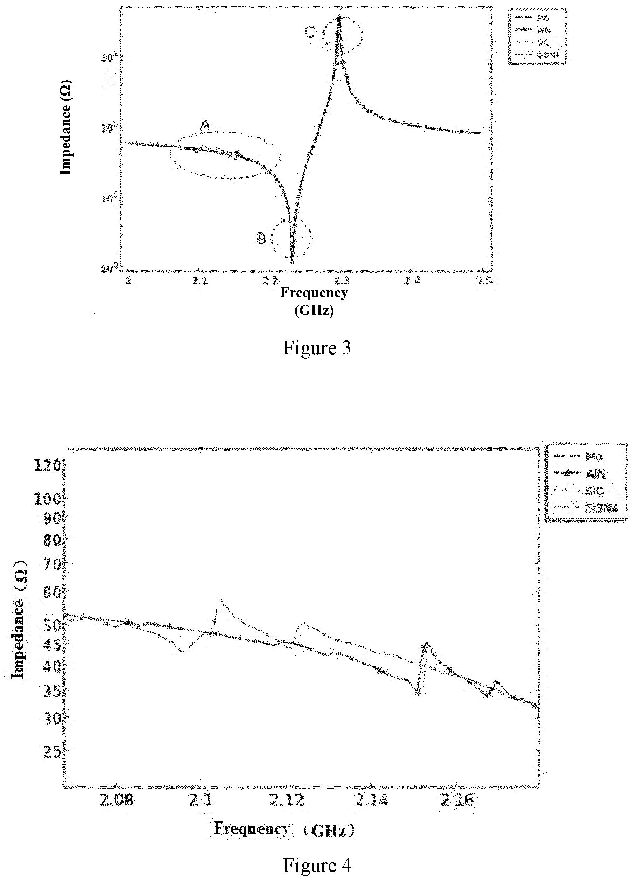

Figure 3 to Figure 7 show simulation results of performance parameters of the control group and the experimental group.

As shown in Figure 3 and Figure 4, the frequency-impedance curves indicate that the experimental group has less clutter near the series resonance frequency and smaller amplitude of the clutter (in the present disclosure, the amplitude represents the difference between the maximum clutter region and the minimum clutter region) compared with the control group.

In an embodiment, in the frame structure 6, the amplitude is 15 when the first material layer 8 is made of molybdenum, and the amplitude is 10 when the first material layer 8 is made of a non-metallic material such as silicon carbide, aluminum nitride, or silicon nitride.

Since a device with smaller amplitude has better performance, an effect of suppressing clutter in a case that the first material layer 8 of the frame structure 6 is made of a non-metallic material such as silicon carbide, aluminum nitride, or silicon nitride is significantly better than an effect of suppressing clutter in a case that the first material layer 8 made of molybdenum is electrically connected to the top electrode 4.

Material properties of molybdenum, aluminum nitride, silicon carbide, and silicon nitride are shown in Table 1.

The acoustic impedance of the frame structure 6 varies as the material of the first passivation layer 9 forming the frame structure 6 varies. The acoustic impedance is calculated according to an equation Z= ρ v, where ρ represents a material density and v represents an acoustic speed of longitudinal wave.

It should be noted that relevant parameters of molybdenum, aluminum nitride, silicon carbide, and silicon nitride vary slightly in different conventional articles.

**Table 1 Comparison of performance parameters of molybdenum, aluminum nitride, silicon carbide, and silicon nitride**

| Material | Kt² | Density g/m³ | Acoustic speed of longitudinal wave Km/m³ | Resistivity Ω/m | Relative permittivity | Young's modulus |
|---|---|---|---|---|---|---|
| Molybdenum (Mo) | 6.69% | 1.02E+04 | 6.214 | 5.17E-10 | NA | 3.12E+11 |
| Aluminum nitride (AlN) | 6.89% | 3.30E+03 | 11.35 | 1013 | 9 | 3.00E+11 |
| Silicon carbide (SiC) | 6.89% | 3 .20E+03 | 11.58 | 1.00E+08 | 10 | 4.00E+11 |
| Silicon nitride (Si₃N₄) | 6.89% | 3.10E+03 | 11 | 1.10E+10 | 9.7 | 2.50E+11 |

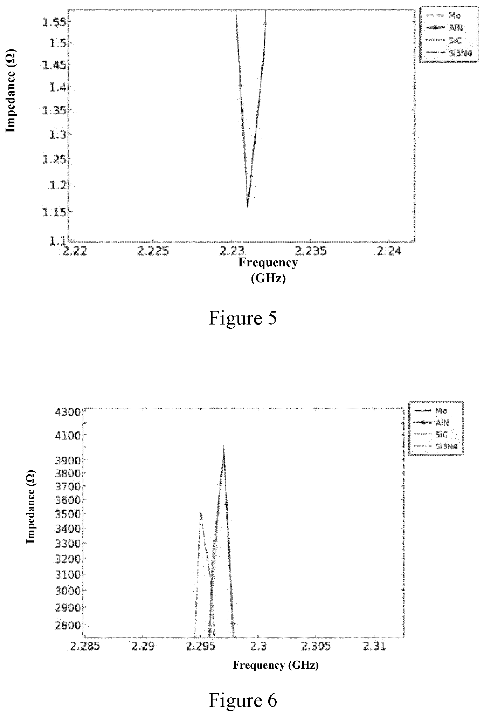

In addition, as shown in Figure 5, near the series resonance frequency fs, Rs and fs of the experimental group basically remain unchanged compared with the control group. In other words, The Rs values and values of series resonance frequency fs respectively corresponding to molybdenum, silicon carbide, aluminum nitride, and silicon nitride are close. That is, the Rs values for different materials are close, all around 1.1 Ω, and fs values are also close, all around 2.231 GHz, which is beneficial for maintaining the quality factor (Qs) at the series resonance frequency.

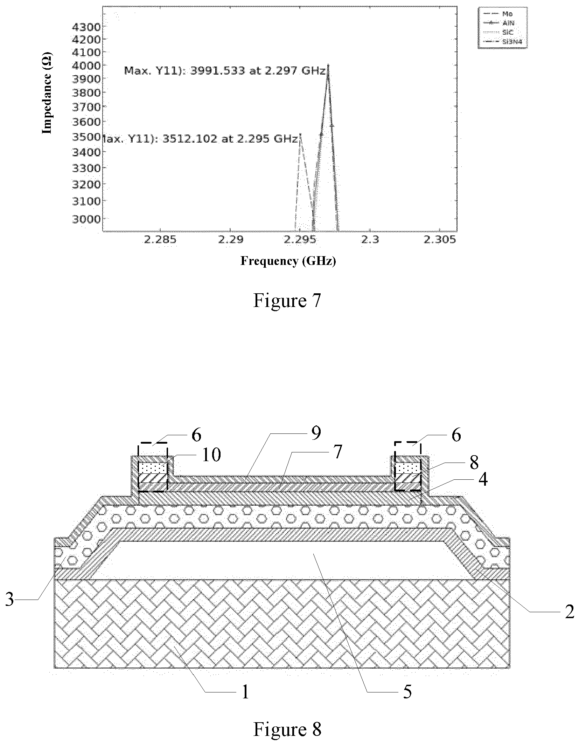

As shown in Figure 6 and Figure 7, Rp of the experimental group near a parallel resonance frequency is significantly increased compared with the control group.

Where, the obtained Rp value varies as the material of the first material layer 8 varies. In a case that the first material layer 8 is made of silicon carbide, the obtained Rp value is 4010Ω. In a case that the first material layer 8 is made of aluminum nitride, the obtained Rp value is 399152. In a case that the first material layer 8 is made of silicon nitride, the obtained Rp value is 392852. In a case that the first material layer 8 is made of molybdenum, the obtained Rp value is 3512Ω.

Since a device with a greater Rp has better performance, the performance of the frame structure 6 made of silicon carbide is better than the performance of the frame structure 6 made of aluminum nitride, the performance of the frame structure 6 made of aluminum nitride is better than the performance of the frame structure 6 made of silicon nitride, and the performance of the frame structure 6 made of silicon nitride is better than the performance of the frame structure 6 in the control group.

It shows that the Rp performance of the experimental group is better than Rp performance of the control group under same setting conditions, which improves the performance of the device significantly. For example, the Rp value in a case that the first material layer 8 in frame structure 6 is made of silicon carbide is increased by 14% compared with the Rp value of the control group.

In addition, comparing with the control group, the quality factor Qp of the experimental group is improved and the experimental group has a better effect of suppressing transverse waves.

Further, comparing with the control group, parallel resonance frequencies (i.e., peak values) in the experimental group are shifted to right and essentially overlapped, with a frequency around 2.297GHz.

In fact, the parallel resonance frequency in the experimental group is increased by about 2MHz compared with the control group (fp is 2.295GHz).

Piezoelectric coupling coefficients are calculated based on the simulation results. Kt² of the bulk acoustic resonator in the experimental group is increased by 0.2% (accounting for 2.99% of the original Kt² 6.69) compared with the control group, that is, increased from 6.69 to 6.89.

Therefore, the performance of the bulk acoustic resonator can be further improved. For example, out-of-band suppression can be improved while maintaining the insertion loss. For example, a yield of the bulk acoustic resonator can be increased by about 3%, thereby directly reducing the cost of mass production of the bulk acoustic resonators.

In other embodiments, the first material layer 8 in the frame structure 6 may also be made of a material different from the materials of the second passivation layer 7 and the first passivation layer 9.

In the second embodiment of the present disclosure, with the first material layer made of a non-metallic material, amplitude of the clutter near fs can be reduced and better Rp performance can be ensured. In addition, Kt² in a case that the first material layer is made of the material with a high acoustic speed can be further increased compared with the control group, thereby improving the performance of the bulk acoustic resonator.

### Third Embodiment

Figure 8 is a schematic cross-sectional view of a bulk acoustic resonator according to a third embodiment of the present disclosure.

The third embodiment of the present disclosure differs from the second embodiment of the present disclosure in that the frame structure 6 in the third embodiment of the present disclosure further includes a second material layer 10, which is arranged between the first material layer 8 and the first passivation layer 9. One end of the second material layer 10 is located within the effective resonance region, and another end of the second material layer 10 aligns with the edge of the effective resonance region.

The second material layer 10 is made of a metal material. Alternatively, the second material layer 10 is made of a non-metallic material different from the materials of the first passivation layer 9 and the second passivation layer 7.

In the third embodiment of the present disclosure, the second material layer is arranged between the first material layer and the first passivation layer, so that the frame structure is a composite structure including multiple layers, to further improve the overall performance of the bulk acoustic resonator.

### Fourth Embodiment

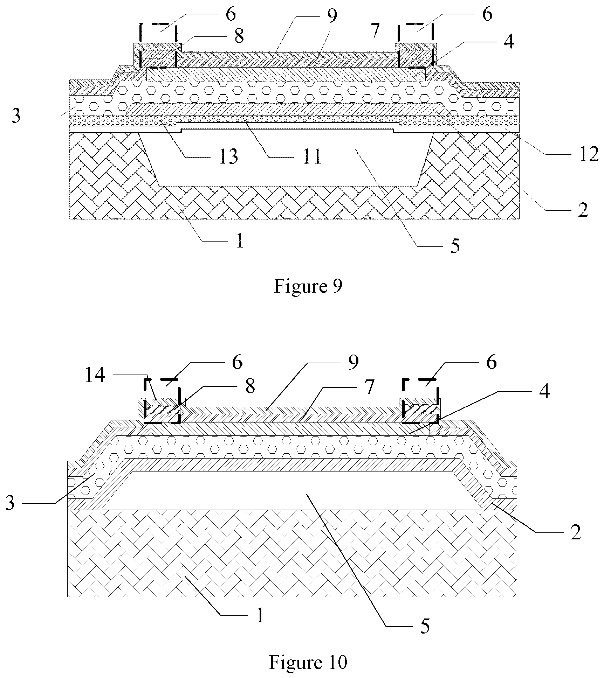

Figure 9 is a schematic cross-sectional view of a bulk acoustic resonator according to a fourth embodiment of the present disclosure.

The fourth embodiment of the present disclosure differs from the first embodiment of the present disclosure in that the frame structure 6 in the fourth embodiment of the present disclosure further includes a first dielectric layer 11 and a second dielectric layer 12. The first dielectric layer 11 is arranged between the bottom electrode 2 and the second dielectric layer 12. In an embodiment, the first dielectric layer 11 is located under the bottom electrode 2 and the piezoelectric layer 3.

The second dielectric layer 12 is located under the first dielectric layer 11. A third material layer 13 is arranged between the first dielectric layer 11 and the second dielectric layer 12. The third material layer 13 is arranged at the edge of the effective resonance region. One end of the third material layer 13 is located within the effective resonance region, and another end of the third material layer extends beyond the edge of the effective resonance region. The acoustic impedance of the effective resonance region corresponding to the third material layer 13 is greater than the acoustic impedance of the effective resonance region outside the third material layer 13.

In an embodiment of the present disclosure, one end of the third material layer 13 aligns with an end of the first material layer 8, and another end of the third material layer 13 exceeds the edge of the effective resonance region.

Since the third material layer 13 is located at the edge of the sound reflection structure 5, another end of the third material layer 13 extends outward along the bottom electrode 2 and the piezoelectric layer 3.

In an embodiment of the present disclosure, the third material layer 13 and the first dielectric layer 11 are made of a same material and may be fabricated as/from a same layer.

In an embodiment of the present disclosure, the first dielectric layer 11 and the second dielectric layer 12 each is made of an insulating material.

### Fifth Embodiment

Figure 10 is a schematic cross-sectional view of a bulk acoustic resonator according to a fifth embodiment of the present disclosure.

The fifth embodiment of the present disclosure differs from the first embodiment of the present disclosure in that the acoustic reflection structure in the fifth embodiment of the present disclosure is located above the surface of the substrate and the frame structure 6 is provided with an uneven structured surface 14.

In an embodiment, the uneven structured surface is arranged on the upper surface of the first material layer. Alternatively, an upper surface of a part of the first passivation layer 9 corresponding to the first material layer 8 is arranged as an uneven structured surface. Alternatively, the upper surface of the first material layer 8 and the upper surface of the part of the first passivation layer 9 corresponding to the first material layer 8 are both arranged as uneven structured surfaces. In this case, an uneven structure on the uneven structured surface of the first passivation layer 9 and an uneven structure on the uneven structured surface of the first material layer 8 are arranged alternatively.

The uneven structured surface 14 forms the uneven structure on the upper surface of the first material layer 8 and/or the upper surface of the first passivation layer 9 corresponding to the first material layer 8 in the frame structure 6. By alternatively arranging the uneven structured surfaces of the first material layer 8 and the corresponding first passivation layer 9 in the frame structure 6, it is beneficial to suppress new parasitic transverse waves introduced by the frame structure 6 near fs.

In the fifth embodiment of the present disclosure, by arranging the uneven structured surfaces, small parasitic transverse waves near fs can be reduced or eliminated.

### Sixth Embodiment

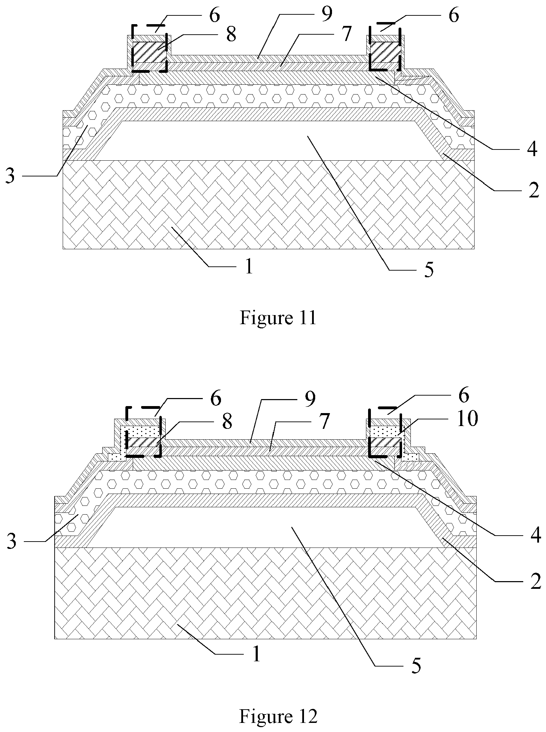

Figure 11 is a schematic cross-sectional view of a bulk acoustic resonator according to a sixth embodiment of the present disclosure.

The sixth embodiment of the present disclosure differs from the first embodiment of the present disclosure in that the cavity in the sixth embodiment of the present disclosure is arranged on the substrate 1 to form an aboveground cavity and the first material layer 8 is made of a metal material. In an embodiment, the first material layer 8 may be made of a high-acoustic-impedance metal such as tungsten, molybdenum, iridium, platinum, ruthenium, or tantalum, etc. For example, the first material layer 8 may be made of a metal with a longitudinal acoustic impedance greater than 50MRayls, e.g., molybdenum with an acoustic impedance of 66MRayls, tungsten with an acoustic impedance of 99MRayls, or ruthenium with an acoustic impedance of 73MRayls.

In an embodiment of the present disclosure, the first material layer 8 may also be made of the material with a high acoustic speed, such as beryllium with an acoustic speed of 12890m/s and lithium with an acoustic speed of 7080m/s.

### Seventh Embodiment

Figure 12 is a schematic cross-sectional view of a bulk acoustic resonator according to a seventh embodiment of the present disclosure.

The seventh embodiment of the present disclosure differs from the first embodiment of the present disclosure in that the cavity in the seventh embodiment of the present disclosure is arranged on the substrate 1, and the frame structure 6 in the seventh embodiment of the present disclosure further includes a second material layer 10 arranged between the first material layer 8 and the first passivation layer 9. The second material layer 10 is made of a metal material. One end of the second material layer 10 is arranged within the effective resonance region, and another end of the second material layer 10 extends beyond the edge of the effective resonance region and extends along an edge of an outer side of the first material layer 8. The outer side of the first material layer 8 is a side away from a center of the effective resonance region, and an inner side of the first material layer 8 is a side close to the center of the effective resonance region.

Near the frame structure 6, the first material layer 8, the first passivation layer 9 on two sides of the first material layer 8, and the second material layer 10 at the outer side of the first material layer 8 as a whole can function as the Bragg reflection layer, which is conducive to limiting the transverse waves within the effective resonance region. In addition, the frame structure 6 is conducive to suppressing clutter near fs.

In the seventh embodiment of the present disclosure, the second material layer 10 is made of a metal material. Since the second passivation layer 7 is provided, the second material layer 10 made of a metal material is electrically isolated from the top electrode 4.

In addition, the second material layer 10 may be made of a non-metallic material different from the material of the second passivation layer 7, or be made of a non-metallic material different from the materials of the first passivation layer 9 and the second passivation layer 7.

Further, after the second material layer 10 extends along the edge of the outer side of the first material layer 8, it may further extends along the surface of the second passivation layer 7, to further reduce the acoustic energy loss caused by the transverse waves. A side structure of the second material layer 10 may be a multi-layer reflection structure surrounding the electrode.

In an embodiment of the present disclosure, the acoustic reflection structure 5 may be a cavity or a Bragg reflection structure.

### Eighth Embodiment

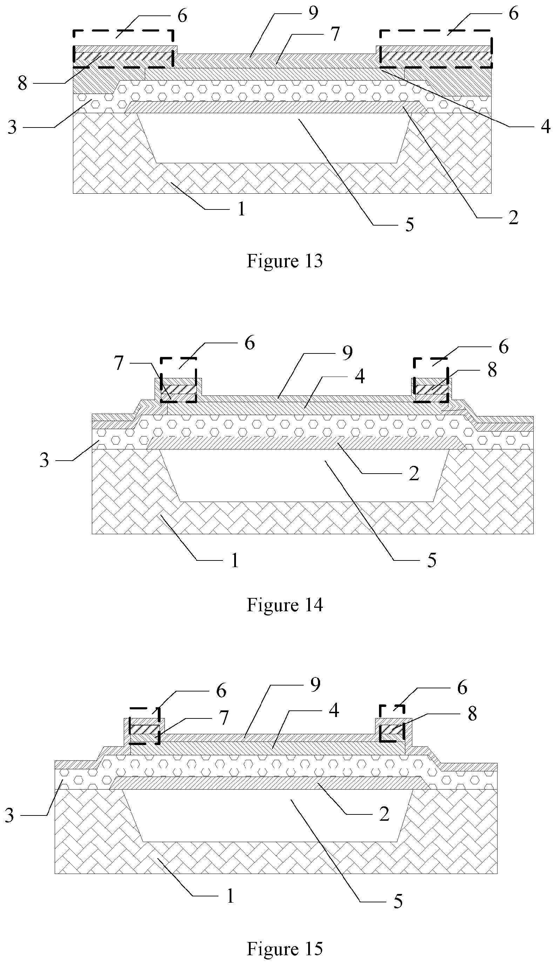

Figure 13 is a schematic cross-sectional view of a bulk acoustic resonator according to an eighth embodiment of the present disclosure.

The eighth embodiment of the present disclosure differs from the first embodiment of the present disclosure in that one end of the frame structure 6 in the eighth embodiment of the present disclosure is located within the effective resonance region, and another end of the frame structure 6 exceeds the edge of the effective resonance region. Heights of the upper surfaces of the first material layer 8 and the second passivation layer 7 remain constant, which means that there is no significant change of the heights and a reasonable manufacturing error in the art is allowed.

### Ninth Embodiment

Figure 14 is a schematic cross-sectional view of a bulk acoustic resonator according to a ninth embodiment of the present disclosure.

The ninth embodiment of the present disclosure differs from the first embodiment of the present disclosure in that the first passivation layer 9 covers the effective resonance region in the ninth embodiment of the present disclosure. In other words, compared with the first embodiment 1 of the present disclosure, the part of the second passivation layer between inner ends of the frame structure 6 is removed when the first passivation layer 9 is formed. Where, the inner ends of the frame structure 6 are ends close to the center of the effective resonance region of the frame structure 6.

### Tenth Embodiment

Figure 15 is a schematic cross-sectional view of a bulk acoustic resonator according to a tenth embodiment of the present disclosure.

The tenth embodiment of the present disclosure differs from the ninth embodiment of the present disclosure in that one end of the frame structure 6 is located within the effective resonance region and another end of the frame structure 6 aligns with the edge of the top electrode 4.

In an embodiment of the present disclosure, the first material layer 8 of the frame structure 6 may be made of a material different from the material of the second passivation layer 7.

### Eleventh Embodiment

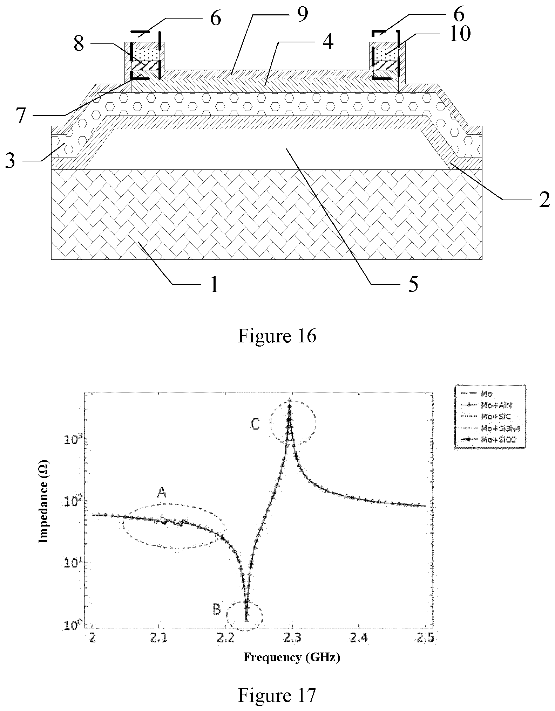

Figure 16 is a schematic cross-sectional view of a bulk acoustic resonator according to an eleventh embodiment of the present disclosure.

The eleventh embodiment of the present disclosure differs from the tenth embodiment of the present disclosure in that the cavity in the eleventh embodiment of the present disclosure is arranged on the substrate 1, and the frame structure 6 in the eleventh embodiment of the present disclosure further includes a second material layer 10 arranged between the first material layer 8 and the first passivation layer 9. One end of the second material layer 10 is located within the effective resonance region, and another end of the second material layer 10 aligns with the edge of the effective resonance region.

In order to compare the performance of the resonator in a case that the first material layer 8 is made of a metal material and the performance of the resonator in a case that the first material layer 8 is made of a non-metallic material, comparative validation is performed by using the structure in the eleventh embodiment of the present disclosure as a simulation device. In a control group, the first material layer 8 is a metal layer made of Mo, and the second passivation layer 7 in the eleventh embodiment is replaced by a metal layer made of Mo. In an experimental group, the first material layer 8 and the second passivation layer 7 are made of a same material, namely silicon carbide, aluminum nitride, or silicon nitride.

In both the control group and the experimental group, the bottom electrode 2 and the top electrode 4 of the simulation device are made of molybdenum. The bottom electrode 2 and the top electrode 4 each has a thickness of 0.3µM. The piezoelectric layer 3 is made of aluminum nitride. The piezoelectric layer 3 has a thickness of 0.8µM. The first passivation layer 9 is made of aluminum nitride. The first passivation layer 9 has a thickness of 0.29µM. The first material layer 8 and the second passivation layer 7 each has a thickness of 0.025µM. The second material layer 10 is made of molybdenum and has a thickness of 0.05µM. The first material layer 8 and the second material layer 10 each has a width of 2µM.

Parameters corresponding to the control group are parameters of the conventional metal protruding structure electrically connected to the top electrode 4. Parameters corresponding to the experimental group are parameters of the structure according to the embodiments of the present disclosure.

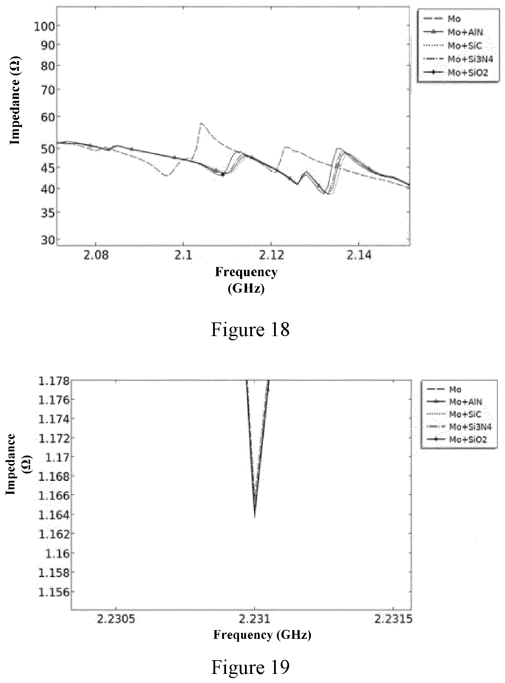

As shown in Figure 17 and Figure 18, the frequency-impedance curves indicate that the experimental group has less clutter near the series resonance frequency and smaller amplitude of the clutter compared with the control group.

In an embodiment, the amplitude in the control group is 15, and the amplitude in the experimental group is 10.

Since a device with smaller amplitude has better performance, an effect of suppressing clutter in the experimental group is significantly better than an effect of suppressing clutter in the control group.

In addition, as shown in Figure 19, near the series resonance frequency fs, Rs and fs of the experimental group essentially remain unchanged compared with the control group. In other words, the Rs values for different materials are close, all around 1.1 Ω and fs values are also close, all around 2.231GHz, which is beneficial for maintaining the quality factor Qs at the series resonance frequency.

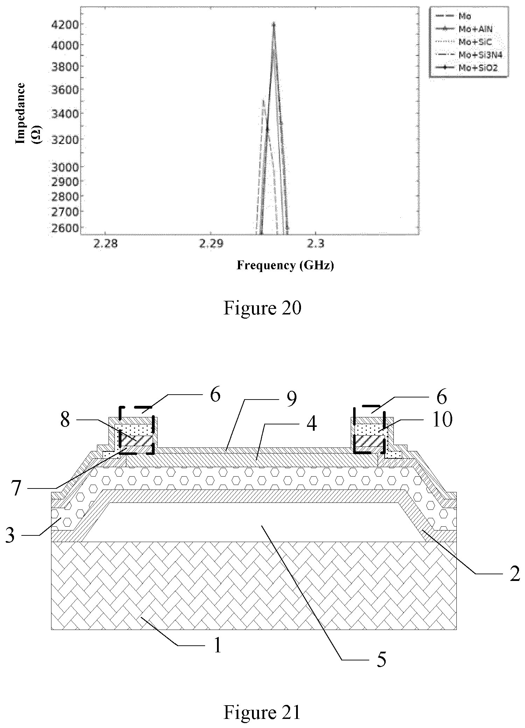

As shown in Figure 20, Rp of the experimental group near a parallel resonance frequency fp is significantly increased compared with the control group. In a case that the first material layer 8 is made of aluminum nitride and the second material layer 10 is a metal material made of molybdenum, the obtained Rp value is 4218Ω. In a case that the first material layer 8 is made of silicon carbide and the second material layer 10 is a metal material made of molybdenum, the obtained Rp value is 4210Ω. In a case that the first material layer 8 is made of silicon nitride and the second material layer 10 is a metal material made of molybdenum, the obtained Rp value is 419452. The obtained Rp value in the control group is 3512Ω.

Since a device with a greater Rp has better performance, the performance of the frame structure 6 made of aluminum nitride and molybdenum is better than the performance of the frame structure 6 made of silicon carbide and molybdenum, the performance of the frame structure 6 made of silicon carbide and molybdenum is better than the performance of the frame structure 6 made of silicon nitride and molybdenum, and the performance of the frame structure 6 made of silicon nitride and molybdenum is better than the performance of the frame structure 6 made of only molybdenum.

It shows that the Rp performance of the experimental group is better than Rp performance of the control group under same setting conditions, which improves the performance of the device significantly.

In addition, comparing with the control group, the quality factor Qp of the experimental group is improved and the experimental group has a better effect of suppressing transverse waves.

Further, comparing with the control group (fp is 2.295GHz), parallel resonance frequencies in the experimental group are shifted to right and essentially overlapped, with a frequency around 2.296GHz, and the parallel resonance frequency is increased by about 1MHz.

In comparison with the performance of the experimental group in the second embodiment, for the experimental group in the eleventh embodiment of the present disclosure, the Rs value is the same as the Rs value of the experimental group in the second embodiment, i.e., about 1.1 Ω . The amplitude of clutter near fs is still suppressed. Nevertheless, Rp value of the experimental group in the eleventh embodiment is better than Rp value of the experimental group in the second embodiment.

In the experimental group of the eleventh embodiment of the present disclosure, Rp value is about 4200. However, in the experimental group in the second embodiment, the maximum Rp value is 4010 in a case that the frame structure 6 is made of SiC. Hence, the Rp value is increased by about 5%. It should be noted that in this case, the amplitude of the clutter remained essentially unchanged.

### Twelfth Embodiment

Figure 21 is a schematic cross-sectional view of a bulk acoustic resonator according to a twelfth embodiment of the present disclosure.

The twelfth embodiment of the present disclosure differs from the seventh embodiment of the present disclosure in that the first passivation layer 9 in the twelfth embodiment of the present disclosure covers the effective resonance region. That is, compared with the seventh embodiment of the present disclosure, the part of the second passivation layer between inner ends of the frame structure 6 is removed when the first passivation layer 9 is formed. The inner ends of the frame structure 6 are ends close to the center of the effective resonance region of the frame structure 6.

### Thirteenth Embodiment

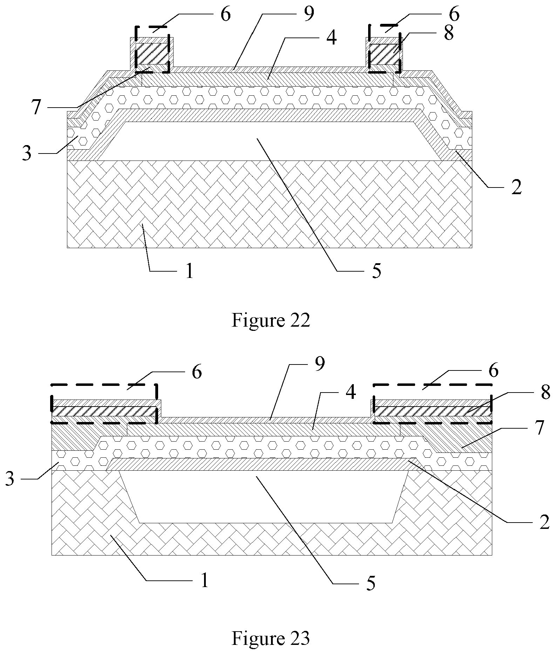

Figure 22 is a schematic cross-sectional view of a bulk acoustic resonator according to a thirteenth embodiment of the present disclosure.

The thirteenth embodiment of the present disclosure differs from the sixth embodiment of the present disclosure in that the first passivation layer 9 in the thirteenth embodiment of the present disclosure covers the effective resonance region. That is, compared with the sixth embodiment of the present disclosure, the part of the second passivation layer between inner ends of the frame structure 6 is removed when the first passivation layer 9 is formed. The inner ends of the frame structure 6 are ends close to the center of the effective resonance region of the frame structure 6.

In other embodiments, the second passivation layer 7 may cover the effective resonance region. That is, compared with the sixth embodiment of the present disclosure, when the first passivation layer 9 is formed, the first passivation layer 9 wraps the second material layer 10 and then the part of the first passivation layer 9 extending towards the effective resonance region is removed.

### Fourteenth Embodiment

Figure 23 is a schematic cross-sectional view of a bulk acoustic resonator according to a fourteenth embodiment of the present disclosure.

The fourteenth embodiment of the present disclosure differs from the eighth embodiment of the present disclosure in that the first passivation layer 9 in the fourteenth embodiment of the present disclosure covers the effective resonance region. That is, compared with the eighth embodiment of the present disclosure, the part of the second passivation layer between inner ends of the frame structure 6 is removed when the first passivation layer 9 is formed. The inner ends of the frame structure 6 are ends close to the center of the effective resonance region of the frame structure 6.

Based on all the bulk acoustic resonators according to the above embodiments of the present disclosures, a method for manufacturing the bulk acoustic resonator is provided according to an embodiment of the present disclosure. The method is used for manufacturing any one of the bulk acoustic resonators according to the above embodiments of the present disclosures. The method includes steps S11 to S14 as follows.

In step S11, a substrate is provided, and a sacrificial layer is formed on the substrate.

In step S11, the substrate includes but is not limited to a Si substrate, a sapphire substrate, and a glass substrate.

The sacrificial layer may be formed by using a dielectric material including but not limited to SiO₂, PSG, Si, Si₃N₄, or PI. The sacrificial layer is subsequently released to obtain an acoustic reflection structure.

In step S12, at least a bottom electrode, a piezoelectric layer, and a top electrode are sequentially formed on the substrate with the sacrificial layer.

In step S12, the bottom electrode may be made of a material including but not limited to tungsten (W), molybdenum (Mo), aluminum (Al), platinum (Pt), ruthenium (Ru), and niobium (Nb).

The piezoelectric layer may be made of AlN or AlScN (ALN doped with Sc).

The piezoelectric layer may be made of AlN doped with yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) or lutetium (Lu), or AlN doped with Mg, Hf, or Zr, Or thin-film LN (Lithium niobate LiNbO₃ or Lithium tantalate LiTaO₃).

The top electrode material may be made of a material including but not limited to tungsten (W), molybdenum (Mo), aluminum (Al), platinum (Pt), ruthenium (Ru), and niobium (Nb).

During the implementation of step S12, at least the bottom electrode, the piezoelectric layer, and the top electrode, having specific structures, are sequentially formed on the substrate with the sacrificial layer.

In step S13, a frame structure is formed at an edge of an effective resonance region.

In step S13, an overlapping region of the bottom electrode, the piezoelectric layer, the top electrode and the acoustic reflection structure is configured as the effective resonance region of the bulk acoustic resonator. The frame structure includes a second passivation layer, a first material layer, and a first passivation layer that are formed above the top electrode.

One end of the frame structure is located within the effective resonance region, and another end of the frame structure extends at least to the edge of the effective resonance region to align with that edge. The acoustic impedance of the effective resonance region corresponding to the frame structure is greater than the acoustic impedance of the effective resonance region that is outside the frame structure.

Where, the second passivation layer may be made of a material including but not limited to polycrystalline silicon, aluminum nitride, silicon dioxide, doped silicon dioxide, silicon carbide, or aluminum oxide.

The first material layer may be made of a metal material or a non-metallic material.

The first passivation layer may be made of a material including but not limited to polycrystalline silicon, aluminum nitride, silicon dioxide, doped silicon dioxide, silicon carbide, or aluminum oxide.

During the implementation of step S13, at least the second passivation layer, the first material layer, and the first passivation layer are formed above the top electrode.

It should be noted that, the acoustic reflection structure is obtained by releasing the sacrificial layer after the first passivation layer is formed.

In step S14, a thickness of the first passivation layer is reduced for frequency modulation. The thickness of the first passivation layer may be reduced for frequency modulation by a physical means and/or a chemical means.

In the embodiments of the present disclosure, a frame structure is arranged at the edge of the effective resonance region configured in the bulk acoustic resonator. The acoustic impedance of the effective resonance region corresponding to the frame structure is greater than the acoustic impedance of the effective resonance region that is outside the frame structure, which effectively suppresses parasitic transverse waves. In addition, the frame structure includes two passivation layers, which reduces clutter caused by additional resonance while suppressing the transverse waves. Further, with the two passivation layers, the stress can be reduced and the structure stability and the Q factor can be improved.

A filter is further provided according to an embodiment of the present disclosure based on the bulk acoustic resonator according to the embodiments of the present disclosure. The filter includes any one of the bulk acoustic resonators according to the embodiments of the present disclosure.

An electronic device is further provided according to an embodiment of the present disclosure based on the bulk acoustic resonator according to the embodiments of the present disclosure. The electronic device includes any one of the bulk acoustic resonators according to the embodiments of the present disclosure.

It should be noted that in the description of the present disclosure, it should be understood that the orientation or positional relationship indicated by the terms, such as "upper", "lower", "top", "bottom", "inner", "outer", is based on the orientation or positional relationship shown in the drawings, for the convenience of describing the present disclosure and simplifying the description, rather than indicating or implying that the referred device or element must have a specific orientation, be constructed and operated in a specific orientation. Therefore, these terms should not be understood as limitations to the present disclosure. If a component is considered to be "connected" to another component, the component may be directly connected to another component or there may be a component arranged between the two components.

It should be further illustrated that relation terms such as "first" and "second" herein are only used to distinguish one entity or operation from another entity or operation, which doe not necessarily require or imply that there is an actual relation or sequence between these entities or operations.

According to the above description of the disclosed embodiments, those skilled in the art can implement or use the present disclosure. Various modifications made to these embodiments may be obvious to those skilled in the art, and the general principle defined herein may be implemented in other embodiments without departing from the spirit or scope of the present disclosure. Hence, the present disclosure is not limited to the embodiments described herein but conforms to a widest scope in accordance with principles and novel features disclosed in the present disclosure.

## Claims

1. A bulk acoustic resonator, comprising:
a substrate;
a bottom electrode, a piezoelectric layer, and a top electrode that are stacked above the substrate;
an acoustic reflection structure, arranged between the substrate and the bottom electrode, wherein an overlapping region of the bottom electrode, the piezoelectric layer, the top electrode, and the acoustic reflection structure is configured as an effective resonance region of the bulk acoustic resonator; and
a frame structure, arranged at an edge of the effective resonance region, wherein the frame structure comprises a second passivation layer, a first material layer, and a first passivation layer that are stacked above the top electrode; one end of the frame structure is located within the effective resonance region, another end of the frame structure extends at least to the edge of the effective resonance region to align with the edge, and an acoustic impedance of an effective resonance region corresponding to the frame structure is greater than an acoustic impedance of an effective resonance region that is outside the frame structure.

2. The bulk acoustic resonator according to claim 1, wherein the first material layer is made of a metal material.

3. The bulk acoustic resonator according to claim 1, wherein the first material layer is made of a non-metallic material.

4. The bulk acoustic resonator according to claim 1, wherein the first material layer and the second passivation layer are fabricated as/from a same layer.

5. The bulk acoustic resonator according to claim 1, wherein the frame structure further comprises a second material layer arranged between the first material layer and the first passivation layer.

6. The bulk acoustic resonator according to claim 5, wherein the second material layer is made of a material different from a material of the first passivation layer and different from a material of the second passivation layer.

7. The bulk acoustic resonator according to claim 5, wherein the second material layer is made of a metal material.

8. The bulk acoustic resonator according to claim 1, wherein both the first passivation layer and the second passivation layer cover the effective resonance region.

9. The bulk acoustic resonator according to claim 1, wherein the first passivation layer covers the effective resonance region, and the second passivation layer is arranged at the edge of the effective resonance region; or the second passivation layer covers the effective resonance region, and the first passivation layer is arranged at the edge of the effective resonance region.

10. The bulk acoustic resonator according to claim 1, wherein an acoustic impedance of the second passivation layer is greater than an acoustic impedance of the first passivation layer.

11. The bulk acoustic resonator according to claim 1, wherein the acoustic impedance of the effective resonance region corresponding to the frame structure is no less than the acoustic impedance of a region that is outside the frame structure.

12. The bulk acoustic resonator according to claim 1, wherein the acoustic reflection structure is a Bragg reflection layer or a cavity.

13. The bulk acoustic resonator according to claim 12, wherein the cavity is arranged inside the substrate or above the substrate.

14. The bulk acoustic resonator according to claim 1, further comprising: a first dielectric layer and a second dielectric layer, wherein the first dielectric layer is arranged between the bottom electrode and the second dielectric layer; a third material layer is arranged between the first dielectric layer and the second dielectric layer, and the third material layer is arranged at the edge of the effective resonance region, one end of the third material layer is located within the effective resonance region, another end of the third material layer extends at least to the edge of the effective resonance region to align with the edge, and an acoustic impedance of an effective resonance region corresponding to the third material layer is greater than an acoustic impedance of an effective resonance region that is outside the third material layer.

15. The bulk acoustic resonator according to claim 14, wherein the third material layer and the first dielectric layer are fabricated as/from a same layer.

16. The bulk acoustic resonator according to claim 1, wherein an upper surface of the first material layer is configured as an uneven structured surface.

17. The bulk acoustic resonator according to claim 5, wherein an upper surface of the second material layer is configured as an uneven structured surface.

18. The bulk acoustic resonator according to claim 16, wherein an upper surface of a part of the first passivation layer corresponding to the first material layer is configured as an uneven structured surface, an uneven structure on the uneven structured surface thereof and an uneven structure on the uneven structured surface of the first material layer are arranged alternatively.

19. The bulk acoustic resonator according to claim 17, wherein an upper surface of a part of the first passivation layer corresponding to the second material layer is configured as an uneven structured surface, an uneven structure on the uneven structured surface thereof and an uneven structure on the uneven structured surface of the second material layer are arranged alternatively.

20. A method for manufacturing a bulk acoustic resonator, comprising:
providing a substrate;
sequentially forming a bottom electrode, a piezoelectric layer, and a top electrode on the substrate and forming an acoustic reflection structure between the substrate and the bottom electrode, wherein an overlapping region of the bottom electrode, the piezoelectric layer, the top electrode and the acoustic reflection structure is configured as an effective resonance region of the bulk acoustic resonator;
forming a frame structure at an edge of the effective resonance region, wherein the frame structure comprises a second passivation layer, a first material layer, and a first passivation layer that are sequentially formed above the top electrode, one end of the frame structure is located within the effective resonance region, another end of the frame structure extends at least to the edge of the effective resonance region to align with the edge, and an acoustic impedance of an effective resonance region corresponding to the frame structure is greater than an acoustic impedance of an effective resonance region that is outside the frame structure.

21. A filter, comprising the bulk acoustic resonator according to any one of claims 1 to 19.

22. An electronic device, comprising the bulk acoustic resonator according to any one of claims 1 to 19.
